# EUROPÄISCHE PATENTSCHRIFT

(11) **EP 2 549 541 B1**
(45) Veröffentlichungstag und Bekanntmachung des Hinweises auf die Patenterteilung: **02.10.2019**
(21) Anmeldenummer: 11174540.2
(22) Anmeldetag: 19.07.2011
(51) Int. Cl.: H01L 29/866, H01L 29/739

(54) **Festkörper-Diode**
Solid body diode
Diode à corps solide

(43) Veröffentlichungstag der Anmeldung: 23.01.2013
(73) Patentinhaber: Elmos Semiconductor Aktiengesellschaft, 44227 Dortmund (DE)
(72) Erfinder: Degenhardt, Jan, 44227 Dortmund (DE)
(74) Vertreter: dompatent von Kreisler Selting Werner - Partnerschaft von Patent- und Rechtsanwälten mbB

(56) Entgegenhaltungen:
- WO-A1-95/17013
- WO-A1-03/054971
- DE-C1- 19 723 747

## Beschreibung

Die Erfindung betrifft eine Festkörper-Diode, d. h. eine einen pn-Übergang aufweisende Halbleiter-Diode, die zur Spannungsstabilisierung in elektrischen Schaltungen eingesetzt wird. Vorzugsweise handelt es sich bei der Festkörper-Diode um eine Zenerdiode, wobei die Erfindung auf derartige Diodentypen nicht beschränkt ist.

Die Funktionsweise von Halbleiter- bzw. Festkörper-Dioden kann auf einem Punch-, Bipolar- oder Zener-Durchbruch basieren, wobei letzterer zwei Durchbruchmechanismen, nämlich einen Tunneldurchbruch sowie einen Avalanche-Durchbruch miteinander vereinigt. Diese beiden zuletzt genannten Mechanismen haben entgegengesetzte Temperatur-Koeffizienten, so dass eine Zenerdiode derart konstruiert werden kann, dass der Temperatur-Koeffizient bzw. die Temperaturabhängigkeit im Arbeitspunkt quasi verschwindet. Daher eignen sich Zenerdioden beispielsweise für die Spannungsstabilisierung. Andere Anwendungen von Zenerdioden nutzen diese als Schutzstruktur gegen Überspannungen in Schaltungen. Dabei steuert eine Zenerdiode zumeist einen Leistungstransistor, der dann die Überspannung abbaut. Die Diode soll dabei bis zum Schutzfall den zu schützenden Signalpfad lediglich mit einem geringen Leckstrom belasten. Außerdem wird nicht nur bei einer Zenerdiode sondern allgemein bei Dioden verlangt, dass die produktionsbedingte Streuung der Größe der Durchbruchspannung möglichst gering gehalten wird.

Eine Diode weist ein oder mehrere hintereinandergeschaltete pn-Übergänge, also aneinander angrenzende n-dotierte Kathoden- und p-dotierte Anodengebiete in einem Halbleitersubstrat auf. Im Falle des Durchbruchs kommt es zu einem Stromfluss, der sich, wie bereits oben kurz erläutert, bei einer Zenerdiode aus einem Tunnelstrom und einem Avalanche-Strom zusammensetzt. Dem "Hauptstrom" im Durchbruchsfall sind parasitäre Ströme, die um den Bereich des Durchbruchs herum fließen, parallel geschaltet. Dies ist dadurch bedingt, dass bei herkömmlichen Dioden-Designs die p- und n-Gebiete über eine relativ große Breite aneinandergrenzen. Der Durchbruchsort ist dabei nicht vorhersehbar und kann längs der Breitenerstreckung grundsätzlich an jedem Ort liegen. Hauptsächlich wird der Durchbruch dort erfolgen, wo die Raumladungszonen ihre geringste Tiefe d.h. geringste Erstreckung in Stromflussrichtung aufweist. Produktionsbedingt ist nämlich die Tiefe der Raumladungszone längs der Breite des pn-Übergangs nicht konstant sondern schwankt.

In WO-A-95/17013 ist eine driftfreie Lawinendurchbruch-Diode beschrieben.

Es ist bereits bekannt, die Breite eines pn-Übergangs einer Festkörper-Diode relativ schmal zu halten, um den Ort des Durchbruchs der Diode zu begrenzen. Beispiele für derartige Festkörper-Dioden sind in DE-C-197 23 747 und WO-A-03/054971 beschrieben. Die in der zuletzt genannten Schrift beschriebenen abgeflachten zugewandten Spitzen der n- und p-dotierten Gebiete sind auch bei dem Dioden-Design gemäß DE-C-197 23 747 gegeben. Die beiden Diodenkonstruktionen gemäß den zuvor genannten Druckschriften können aber noch unter parasitären Effekten leiden, was die Funktionszuverlässigkeit einschränkt. Dabei ist ferner zu beachten, dass in DE-C-197 23 747 eine Zapping-Diode beschrieben ist, deren Einsatz auf einen irreversiblen Durchbruch gerichtet ist, eine hohe Stromfähigkeit also unerwünscht ist.

Aufgabe der Erfindung ist es, eine bezüglich ihrer Funktionalität zuverlässiger arbeitende Festkörper-Diode zu schaffen.

Zur Lösung dieser Aufgabe wird mit der Erfindung eine Festkörper-Diode vorgeschlagen, die versehen ist mit den Merkmalen des Anspruchs 1. Die Gegenstände der abhängigen Ansprüche betreffen einzelne Ausgestaltungen der Erfindung.

Bei dieser Festkörper-Diode ist erfindungsgemäß vorgesehen,
- dass die Maskierungsgebiete und entweder das Kathodenanschlussfeld oder das Anodenanschlussfeld auf dem gleichen elektrischen Potential liegen, d. h. entweder direkt oder indirekt elektrisch miteinander verbunden/gekoppelt sind.

Bevor die Erfindung im Detail erläutert wird, sei ganz grundsätzlich erwähnt, dass die erfindungsgemäße Diode üblicherweise in einer innerhalb eines (Halbleiter-)Substrats eingebrachten Wannenstruktur (sogenannter body), bestehend aus einer n-Wanne oder einer p-Wanne in einer n-Wanne, eingebettet sein kann, so dass der Betrieb der Diode oberhalb oder unterhalb des Substratpotentials (Substrat hierbei z.B. p-Typ) erfolgen kann. Die Bezeichnung "Halbleiter-Substrat" im folgenden Text ist daher entsprechend zu verstehen.

Bei der erfindungsgemäßen Festkörper-Diode sind die beiden einen pn-Übergang bildenden Kathoden- und Anoden-Gebiete selbstjustierend ausgebildet und ausgerichtet, und zwar durch die beiden einander gegenüberliegenden Maskierungsgebiete mit ihren voneinander beabstandeten und gegenüberliegenden Begrenzungsrandabschnitten. In dem Bereich zwischen diesen beiden Maskierungsgebieten bildet sich der eigentliche pn-Übergang aus, über den der Durchbruchstrom fließt. Außerhalb der Maskierungsgebiete können die Kathoden- und Anodengebiete breiter als innerhalb des Maskierungsgebietes ausgeführt sein.

Herkömmlicherweise werden pn-Übergänge von Dioden in dotierten Wannengebieten von Halbleitersubstraten ausgebildet. Diese Halbleitersubstrate sind (schwach) p- oder n-dotiert. Die eigentlichen Kathoden- und Anodengebiete sind stark n- bzw. p-dotiert und damit höher dotiert als das Halbleitersubstrat. Diese Integration des pn-Übergangs in Wannengebiete erlaubt den Betrieb der Diode über oder unterhalb des Potentials des Halbleitersubstrats.

Durch die Beabstandung der n- und p-dotierten Kathoden- und Anoden-Gebiete der erfindungsgemäßen Festkörper-Diode außerhalb des Bereichs zwischen den beiden Maskierungsgebieten und zwar dort, wo die beiden Kathoden- und Anoden-Gebiete um die Erstreckung der Maskierungsgebiete in Stromrichtung voneinander beabstandet sind, kann der sogenannte GIDL-Effekt (gate-induced drain leakage) auftreten. Dieser Effekt tritt bei einem p-Halbleitersubstrat am Übergang des Kathodengebiets, bzw. bei einem n-Halbleitersubstrat am Übergang des Anodengebiets zum Halbleitersubstrat, jeweils unterhalb des Maskierungsgebiets auf. Dadurch aber, dass erfindungsgemäß das Kathodenanschlussfeld (oder alternativ das Anodenanschlussfeld) auf dem gleichen elektrischen Potential liegt wie die Maskierungsgebiete, wird diesem GIDL-Effekt unterhalb der Maskierungsgebiete entgegengewirkt. Durch die erfindungsgemäße Beschaltung folgt das Potential der Maskierungsgebiete dem des Kathodengebiets bzw. dem des Anodengebiets, je nachdem, ob das Maskierungsgebiet mit dem Kathoden- oder mit dem Anodengebiet elektrisch verbunden ist, und erzeugt damit an der Oberfläche des Halbleitersubstrats unterhalb des Maskierungsgebiets einen Inversionskanal. Durch diese Beschaltung entsteht ein parasitärer MIS-(Metal-Isolator-Semiconductor-) Kondensator.

Die erfindungsgemäße Festkörper-Diode mit ihrem eingeschnürten pn-Übergang und ihren selbstjustierend ausgerichteten Anoden- und Kathodengebiete (nämlich dort, wo der Durchbruchstrom entsteht,) sowie durch ihre Beschaltung, indem das Kathodenanschlussfeld oder alternativ das Anodenanschlussfeld auf dem gleichen elektrischen Potential wie die Maskierungsgebiete liegt, garantiert eine zuverlässige und reproduzierbare Funktionalität und weist daher schaltungstechnisch vorteilhafte Eigenschaften auf, die insbesondere von Vorteil sind beim Einsatz der Festkörper-Diode für die Spannungsstabilisierung und die Spannungsbegrenzung, was beides aber insbesondere bei einer Zapping-Diode, wie sie in DE-C- 197 23 747 beschrieben ist, eben gerade nicht gewollt ist.

In zweckmäßiger Weiterbildung der Erfindung ist vorgesehen, dass das n-dotierte Kathodengebiet durch eine Ionenimplantation erzeugt wird, wobei die Ionen dieser Implantation eine relativ geringe Beweglichkeit innerhalb des Halbleitersubstrates aufweisen, das implantierte Gebiet sich also bei der üblicherweise erfolgenden thermischen Diffusion kaum ausdehnt. Demgegenüber wird für das p-dotierte Anodengebiet ein Dotierstoff verwendet, der eine relativ große Beweglichkeit innerhalb des Halbleitersubstrates aufweist. Bei einer thermischen Diffusion dehnt sich also das implantierte p-dotierte Anodengebiet deutlich weiter aus als das n-dotierte Kathodengebiet. Daher wird nach der n-Dotierungsionenimplantation und vor der p-Dotierungsionenimplantation zumindest entlang der einander zugewandten Begrenzungsrandabschnitte der beiden Maskierungsgebiete ein Maskierungsrandstreifen (vergleichbar mit einem sogenannten Spacer an dem Polysilizium-Gate eines Transistors) abgeschieden, so dass durch die p-Ionenimplantation an das n-dotierte Kathodengebiet angrenzend ein gegenüber diesem um die Breite der gegenüberliegenden Maskierungsrandstreifen schmaleres, mittenzentriertes p-dotiertes Gebiet innerhalb des Halbleitersubstrates erzeugt wird. Bei der anschließenden thermischen Behandlung des Halbleitersubstrates dehnt sich das p-dotierte Gebiet bis unterhalb der Maskierungsrandstreifen aus, wird also breiter und erreicht damit im Wesentlichen die Breite des n-dotierten Gebiets.

Bei dem ersten Maskierungsmaterial handelt es sich zweckmäßigerweise um polykristallines Silizium, das ggf. silizidiert sein kann. Bei dem zweiten Maskierungsmaterial, das in der Halbleiterbauelement-Fertigungsindustrie auch als "Spacer" bekannt ist, handelt es sich zweckmäßigerweise um Siliziumnitrid.

Die Erfindung wird nachfolgend anhand eines Ausführungsbeispiels und unter Bezugnahme auf die Zeichnung näher erläutert. Im Einzelnen zeigen dabei:
- Fign. 1 bis 10: Draufsichten auf ein Halbleitersubstrat sowie spezielle Querschnitte durch das Halbleitersubstrat in den verschiedenen Verfahrensstadien der Herstellung eines Ausführungsbeispiels der Diode,
- Fig. 11: eine Querschnittsansicht zur Erläuterung des GIDL-Effekts und
- Fig. 12: ein Ersatzschaltbild der Diode.

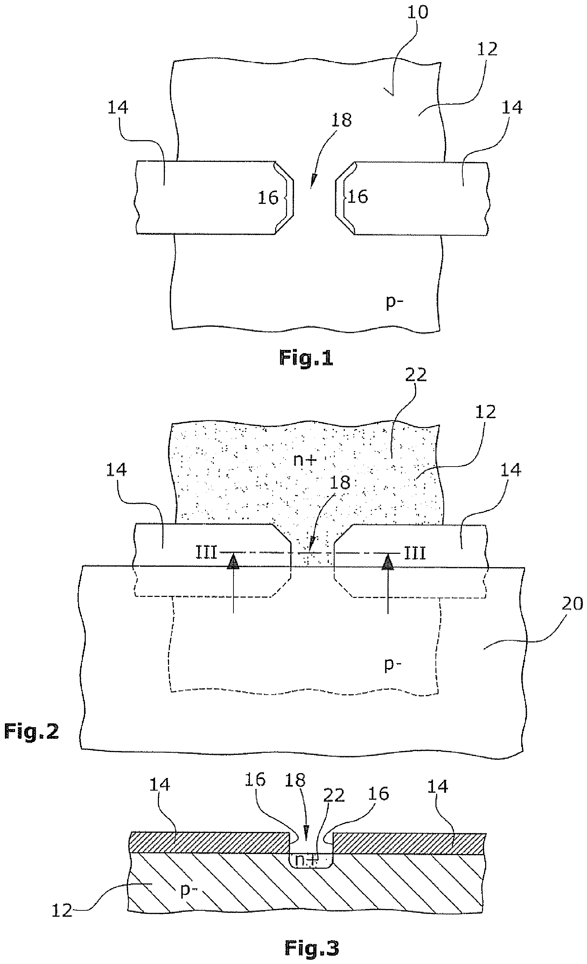

In Fig. 1 ist in Draufsicht ein Ausschnitt auf die Oberseite 10 eines schwach p-dotierten Wannengebietes eines Silizium-Halbleitersubstrats 12 gezeigt, auf dem zwei in diesem Ausführungsbeispiel jeweils streifenförmige Maskierungsgebiete 14 aus poly-kristallinem Silizium ausgebildet sind. Die beiden Maskierungsgebiete 14 weisen einander zugewandte Begrenzungsrandabschnitte 16 auf, die voneinander beabstandet sind und einen Einschnürungsbereich bzw. Zwischenraum 18 an zwei gegenüberliegenden Seiten begrenzen. In diesem Zwischenraum 18 bildet sich der pn-Übergang der herzustellenden Festkörper-Diode aus, was anhand der weiteren Fign. nachfolgend näher beschrieben ist.

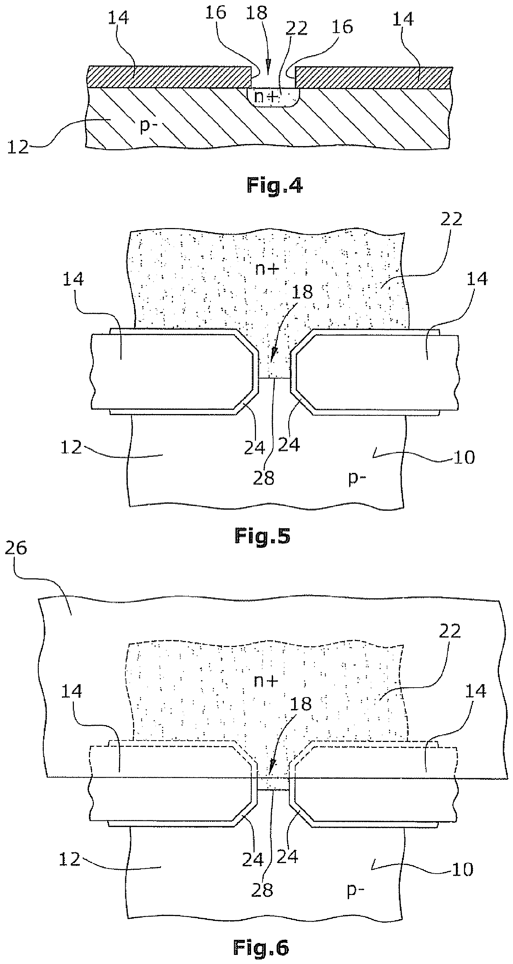

Wie in Fig. 2 gezeigt, wird der in der Darstellung gemäß Fig. 2 unterhalb der Maskierungsgebiete 14 liegende Teil der Oberseite 10 des Halbleitersubstrats 12 durch eine für eine Ionenimplantation undurchlässige Maske 20 abgedeckt, wobei diese Maske 20 bis in den Zwischenbereich 18 hineinragt und sich auch über einen Teil der Maskierungsgebiete 14 erstreckt. Nun erfolgt eine Ionenimplantation zur Erzeugung des n-leitenden Kathodengebiets 22. Das Profil des Kathodengebiets 22 im Bereich des Zwischenraums 18 nach der Ionenimplantation ist in der Querschnittsansicht gemäß Fig. 3 gezeigt. Um die Kristallgitterstörungen im implantierten Kathodengebiet 22 "auszuheilen", erfolgt ein thermischer Behandlungsschritt, der zu einer thermischen Diffusion führt. Bei dem n-leitenden Dotierstoff handelt es sich beispielsweise um Arsen-Atome, die aufgrund ihrer Größe nur eine relativ geringe Beweglichkeit innerhalb des Siliziums haben. Daher dehnt sich das dotierte Kathodengebiet 22 nur geringfügig aus, wie dies in Fig. 4 im Querschnitt gezeigt ist.

Im nächsten Herstellungsschritt wird, wie in Fig. 5 dargestellt, längs der Ränder der Maskierungsgebiete 14 jeweils ein Maskierungsrandstreifen 24 abgeschieden. Die hierzu erforderlichen Herstellungsverfahren sind grundsätzlich von der Herstellung von sogenannten Spacern (beispielsweise aus Siliziumnitrid) bei Polysilizium-Gates von Transistoren bekannt und werden daher an dieser Stelle nicht weiter erläutert.

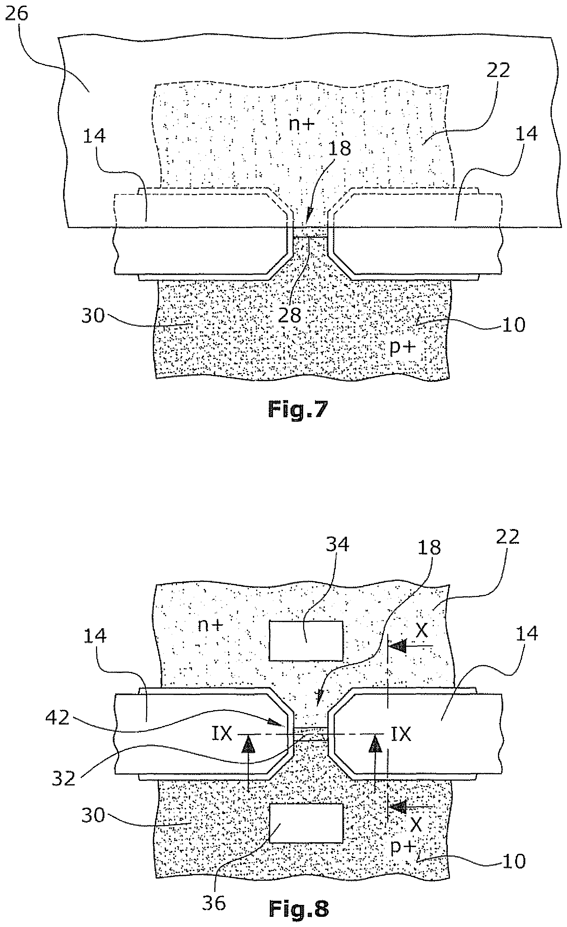

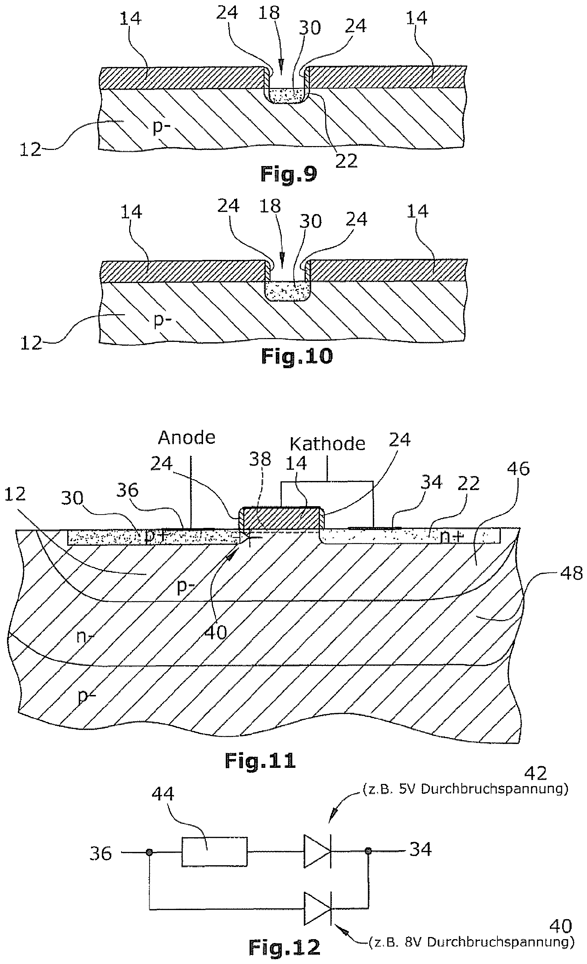

In Fig. 6 ist gezeigt, dass das bereits implantierte Kathodengebiet 22 durch eine Maske 26 abgedeckt wird, die innerhalb des Zwischenraumes 18 gegenüber der Begrenzung 28 des Kathodengebiets 22 geringfügig zurückspringt. Nach Erstellung dieser Maske 26 erfolgt eine Ionenimplantation aus einem p-Dotierstoff (beispielsweise Bor), um das Anodengebiet 30 zu erzeugen(siehe Fig. 7). Anhand von Fign. 7 und 8 ist zu erkennen, dass die Kathoden- und Anodengebiete 22, 30 im Bereich des Zwischenraums 18 einander überlappen (siehe Bezugszeichen 32). Ferner sind in Fig. 8 ein Kathodenanschlussfeld 34 sowie ein Anodenanschlussfeld 36 gezeigt. Das Profil der n- und p-leitenden Dotierstoffe im Zwischenraum 18 nach den Implantationen zeigt Fig. 9. Zu erkennen ist die weniger weite Ausdehnung des implantierten p-Gebiets 30 in Lateralerstreckung, was mit den Spacer-Maskierungsrandstreifen 24 zusammenhängt. Bei der anschließenden thermischen "Ausheilung" der Kristallgitterstruktur im Silizium des Halbleitersubstrats 12 dehnt sich das Anodengebiet 30 lateral aus und ragt bis unter die Spacer-Maskierungsrandstreifen 24, womit es im Wesentlichen die gleiche Lateralerstreckung aufweist wie das Kathodengebiet 22 (siehe Fig. 10).

Anhand von Fig. 11 wird auf eine weitere Besonderheit der erfindungsgemäßen Festkörper-Diode eingegangen. Zu erkennen ist, dass aufgrund der Ausdehnung der Maskierungsgebiete 14 in Richtung des Stromflusses durch die Diode deren Kathoden- und Anodengebiete 22, 30 außerhalb der Maskierungsgebiete 14 voneinander beabstandet sind. Dadurch, dass das Kathodengebiet 22 und die aus polykristallinem Silizium bestehenden Maskierungsgebiete 14 auf dem gleichen Potential liegen (siehe Fig. 11 die elektrische Verbindung zwischen diesen Gebieten), wird vorteilhafterweise der sogenannt GIDL-Effekt (gate-induced drain leakage) an dem Übergang des Kathodengebiets 22 zum schwach p-dotierten Silizium-Halbleitersubstrat 12 unterhalb der Maskierungsgebiete 14 vermieden. Das Potential der Maskierungsgebiete 14 folgt also demjenigen des Kathodengebiets 22 und erzeugt einen Inversionskanal 38 an der Oberfläche des schwach p-dotierten Silizium-Halbleitersubstrats 12 unterhalb der Maskierungsgebiete 14. Durch den Inversionskanal 38 fließen Ladungen vom Kathodengebiet 22 zum Anodengebiet 30. Am Übergang des Inversionskanals 38 zum Anodengebiet 30 entsteht ein parasitärer pn-Übergang (Diode 40).

Der zuvor genannte und in seinen Grundzügen kurz dargelegte GIDL-Effekt ist für die Erfindung von zweifacher vorteilhafter Bedeutung, und zwar zum einen bezüglich seiner Unterdrückung auf der Kathodenseite und zum anderen bezüglich seines gewinnbringenden Effekts auf der Anodenseite der beispielhaft in den Fign. gezeigten Diode. Beides soll im Folgenden nochmals ausführlich erläutert werden.

Zur begrifflichen Klärung ist der bipolare Übergang zwischen dem invertierten Kanal 38 und dem p Anodengebiet 30 als parasitäre Diode 40 bezeichnet. Die den Zenereffekt bestimmende Diode, gebildet durch den pn-Übergang im Zwischenraum 18, sei mit "primärer Diode" 42 bezeichnet. Die Diode kann in eine Wannenstruktur (body), bestehend aus n-Wanne oder einer p- in n-Wanne 46,48 (siehe Fig. 11) eingebettet sein, so dass der Betrieb der Diode über oder unter Substratpotential (Substrat hierbei p-Typ) erfolgen kann. Für spezielle Anwendungen kann die isolierende n-Wanne aber entfallen und der p-body entspricht dann dem p-Substrat; vergleichbares gilt im umgekehrten Fall (n-body in n-Substrat). Die Bezeichnung "Halbleitersubstrat" trifft im engeren Sinne somit nur den exemplarischen Fall eines p-body ohne n-Wanne im p-Substrat.

Die Funktionsweise der erfindungsgemäßen Diode lässt sich durch unterschiedliche Beschaltung des Maskierungsgebiets 14 verändern. Das Maskierungsgebiet 14 kann mit dem Kathodengebiet 22 oder mit dem Anodengebiet 30 elektrisch verbunden werden. Darüber hinaus lässt sich die erfindungsmäße Diode mit einem p- oder einem n-body aufbauen. Konzentriert man sich auf die zwei Varianten des body und die zwei Varianten der Kontaktierung, so ergeben sich insgesamt vier mögliche Konstellationen. Exemplarisch wird nachfolgend auf die Konstruktion der Diode mit p-body - ohne isolierende Wanne, somit äquivalent zum p-Substrat - und die elektrische Verbindung von Kathodengebiet 22 und Maskierungsgebiet 14 eingegangen.

Trägt das Halbleitersubstrat eine netto p-Dotierung und wird das Kathodengebiet 22 mit dem Maskierungsgebiet 14 verbunden, so stellt sich beim Betrieb der Diode in Sperrrichtung eine Inversion der Bandbesetzung unter dem Maskierungsgebiet 14 ein. Das Kathodengebiet 22 (n- dotiert) ist dann leitend mit dem entstandenen n-leitenden (Inversion-)Kanal 38 verbunden. Der in Fig. 11 nicht gezeigte zuvor vorhandene laterale pn-Übergang zwischen der oberflächennahen p-Substrat Schicht unterhalb des Maskierungsgebiets 14 und dem Kathodengebiet 22 ist durch die Erzeugung des Inversions-Kanals 38 aufgehoben und der GIDL Effekt wird daher an dieser Stelle der Konstruktion gegenstandslos.

Auf der in Längsrichtung betrachtet entgegengesetzten Seite des Maskierungsgebietes 14 stößt das Inversions-Kanalgebiet an die p- Dotierung des Anodengebietes 30. Dieser (n-Kanal) - (p⁺⁺)- Übergang hat eine, im Vergleich zum pn-Übergang der primären Diode 42, größere Raumladungszone aufgrund der geringeren Bandverbiegung durch den Inversionskanal als (p⁺⁺)-Gegenpol. Die Durchbruchspannung liegt im Allgemeinen weit über der Durchbruchspannung der primären Diode. Die erfindungsgemäße Diode besteht folglich aus zwei parallel geschalteten Diodenstrecken, nämlich der primären Diode 42, die bei kleinen Spannungen (z. B. 5V) in den Durchbruch geht, und der parasitären Diode, die bei höheren Spannungen (z. B. 8V) in den Durchbruch geht. Das entsprechende Ersatzschaltbild ist in Fig. 12 gezeigt. Diese gesperrte parasitäre Diode 40 wird ohne das positive Potential des Kathodengebietes 22 (die Diode 40 wird "revers" betrieben), das auch an dem Maskierungsgebiet 14 anliegt, in dem Funktionsbereich der primären Diode 42 inaktiv bleiben.

Das infolge der elektrischen Verbindung mit dem Kathodenanschlussfeld 34 elektrisch negativ geladene Maskierungsgebiet 14 initiiert eine Schwächung der gesperrten parasitären Diode 40 (GIDL Effekt). Hierdurch verschiebt sich die Durchbruchspannung der parasitären Diode 40 zu kleineren Werten. Bei passender Wahl der Konstruktion der erfindungsgemäßen Diode liegt die Durchbruchspannung der parasitären Diode 40 (geringfügig) oberhalb der Durchbruchspannung der primären Diode 42.

Der Zwischenraum 18 und dessen Dotierung stellen einen elektrischen Widerstand 44 (siehe Fig. 12) dar, der den Strom über die primäre Diode 42 beschränkt. Mit zunehmender Stromstärke wird dieser Zuleitungswiderstand in der Strom-Spannungs-Charakteristik der primären Diode 42 dominant, nähert sich also einem linearen Verhalten, was den Einfluss der primären Diode 42 dämpft. Ab einer bestimmten Spannung führt der GIDL Effekt zur Leckage der parasitären Diode 40, die mit steigender Spannung zunehmend Strom an der primären Diode 42 vorbeiführt. Da sich die parasitäre Diode 40 längs der gesamten Kante des Maskierungsgebiets 14 zum Anodengebiet 30 erstreckt, somit nahezu die Weite des gesamten Maskierungsgebiets (Halbleitersubstrates) einnimmt, kann diese parasitäre Diode 40 einen sehr großen Strom tragen.

Dieser Mechanismus sorgt bei geringen an der erfindungsgemäßen Diode anliegenden Spannungen für einen niedrigen Leckstrom. Für Spannungen oberhalb der Durchbruchspannung der primären Diode 42 wird die parasitäre Diode 40 über den GIDL Effekt aktiviert und trägt zum Stromtransport bei. Die erfindungsgemäße Diode enthält somit einen inneren leistungsstarken Schutzmechanismus gegen Stromspitzen, weist aber zugleich einen präzisen Durchbruchsort bei einer hohen Spannungsstabilität auf, hat also zwei Eigenschaften, die bei einer Zapping-Diode, wie sie Gegenstand der DE-C-197 23 747 ist, nicht gewünscht sind.

### BEZUGSZEICHENLISTE

- 10: Oberseite
- 12: Halbleitersubstrat,
- 14: Maskierungsgebiete
- 16: Begrenzungsrandabschnitte
- 18: Zwischenraum
- 20: Maske
- 22: Kathodengebiet
- 24: Maskierungsrandstreifen
- 26: Maske
- 28: Begrenzung
- 30: Anodengebiet
- 32: Überlappungsbereich von Kathoden- und Anwendungsgebieten
- 34: Kathodenanschlussfeld
- 36: Anodenanschlussfeld
- 38: Inversionskanal
- 40: parasitäre Diode des Ersatzschaltbildes
- 42: primäre Diode des Ersatzschaltbildes
- 44: Widerstand des Ersatzschaltbildes

## Patentansprüche

1. Spannungsbegrenzung- und -stabilisierungs-Festkörper-Diode mit
- einem Halbleitersubstrat (12) mit einer Oberseite (10),
- zwei auf der Oberseite (10) des Halbleitersubstrates (12) ausgebildeten Maskierungsgebieten (14) aus einem für eine Ionenimplantation undurchlässigen ersten Maskierungsmaterial, wobei die Maskierungsgebiete (14) zwei einander gegenüberliegende Begrenzungsrandabschnitte (16) aufweisen,
- einem in dem Halbleitersubstrat (12) ausgebildeten und bis in den Zwischenraum (18) zwischen den gegenüberliegenden Begrenzungsrandabschnitten (16) der Maskierungsgebiete hineinragenden n-dotierten Kathodengebiet (22) mit einem Kathodenanschlussfeld (34) und
- einem in dem Halbleitersubstrat (12) ausgebildeten und bis in den Zwischenraum (18) zwischen den gegenüberliegenden Begrenzungsrandabschnitten (16) der Maskierungsgebiete (14) hineinragenden sowie an das Kathodengebiet angrenzenden und/oder dieses überlappenden, p-dotierten Anodengebiet (30) mit einem Anodenanschlussfeld (36),
- wobei die Maskierungsgebiete (14) und entweder das Kathodenanschlussfeld (34) oder das Anodenanschlussfeld (36) auf dem gleichen elektrischen Potential liegen.

2. Spannungsbegrenzung- und -stabilisierungs-Festkörper-Diode nach Anspruch 1, **dadurch gekennzeichnet, dass** zumindest längs jedem der einander zugewandten Begrenzungsrandabschnitte (16) der Maskierungsgebiete (14) ein Randstreifen (24) aus einem für eine Ionenimplantation undurchlässigen zweiten Maskierungsmaterial ausgebildet ist.

3. Spannungsbegrenzung- und -stabilisierungs-Festkörper-Diode nach Anspruch 1 oder 2, **dadurch gekennzeichnet, dass** das erste Maskierungsmaterial elektrisch leitend und z. B. polykristallines, insbesondere silizidiertes polykristallines Silizium ist und dass das zweite Maskierungsmaterial Siliziumoxid oder -Nitrid ist.

## Claims

1. A voltage-limiting and voltage-stabilizing solid-state diode comprising
- a semiconductor substrate (12) having a top side (10),
- two masking regions (14) formed on the top side (10) of the semiconductor substrate (12) and made of a first masking material impermeable to ion implantation, said masking regions (14) comprising two mutually opposite limiting edge portions (16),
- an n-doped cathode region (22) formed in the semiconductor substrate (12) and extending up into the intermediate region (18) between said mutually opposite limiting edge portions (16) of the masking regions, said n-doped cathode region (22) comprising a cathode connection field (34), and
- a p-doped anode region (30) formed in the semiconductor substrate (12) and extending up into the intermediate region (18) between said mutually opposite limiting edge portions (16) of the masking regions (14) and bordering on the cathode region and/or overlapping the same, said p-doped anode region (30) comprising an anode connection field (36),
- wherein the masking regions (14) and either the cathode connection field (34) or the anode connection field (36) are on the same electric potential.

2. The voltage-limiting and voltage-stabilizing solid-state diode of claim 1, **characterized in that** an edge strip (24) of a second masking material impermeable to ion implantation is formed at least along each of the mutually facing limiting edge portions (16) of the masking regions (14).

3. The voltage-limiting and voltage-stabilizing solid-state diode of claim 1 or 2, **characterized in that** the first masking material is electrically conducting and is e.g. a polycrystalline, in particular silicidized polycrystalline silicon, and that the second masking material is silicon oxide or silicon nitride.

## Revendications

1. Diode à semi-conducteurs de stabilisation et de limitation de tension comprenant
- un substrat semi-conducteur (12) pourvu d'un côté supérieur (10),
- deux régions de masquage (14) formées sur le côté supérieur (10) du substrat semi-conducteur (12) et contenant un premier matériau de masquage imperméable à une implantation ionique, lesdites régions de masquage (14) comportant deux parties de bord de limitation (16) opposées l'une à l'autre,
- une région de cathode dopée n (22) qui est formée dans le substrat semi-conducteur (12), qui fait saillie jusque dans l'espace intermédiaire (18) ménagé entre les parties de bord de limitation opposées (16) des régions de masquage et qui comprend une zone de raccordement de cathode (34) et
- une région d'anode dopée p (30) qui est formée dans le substrat semi-conducteur (12), qui fait saillie jusque dans l'espace intermédiaire (18) ménagé entre les parties de bord de limitation opposées (16) des régions de masquage (14) et qui comprend une zone de raccordement d'anode (36) et
- les régions de masquage (14) et soit la zone de raccordement de cathode (34) soit la zone de raccordement d'anode (36) étant au même potentiel électrique.

2. Diode à semi-conducteurs de stabilisatrice et de limitation de tension selon la revendication 1, **caractérisée en ce qu'**une bande de bord (24) contenant un deuxième matériau de masquage imperméable à une implantation ionique est formée au moins le long de chacune des parties de bord de limitation (16) se faisant face des régions de masquage (14).

3. Diode à semi-conducteurs de stabilisatrice et de limitation de tension selon la revendication 1 ou 2, **caractérisée en ce que** le premier matériau de masquage est électriquement conducteur et est par exemple du silicium polycristallin, en particulier polycristallin silicidé et **en ce que** le deuxième matériau de masquage est de l'oxyde ou du nitrure de silicium.
